# DEMANDE DE BREVET EUROPEEN

(11) **EP 4 265 826 A1**
(43) Date de publication de la demande: **25.10.2023**
(21) Numéro de dépôt: 23168805.2
(22) Date de dépôt: 19.04.2023
(51) Int. Cl.: C30B 7/02, C30B 29/12

(54) **PROCÉDÉ DE FABRICATION D'UNE COUCHE DE PÉROVSKITE À MULTI-CATIONS**

(30) Priorité: 21.04.2022 FR 2203721
(71) Demandeur: COMMISSARIAT À L'ÉNERGIE ATOMIQUE ET AUX ÉNERGIES ALTERNATIVES, 75015 Paris (FR)
(72) Inventeur: MANCEAU, Matthieu, 38054 Grenoble cedex 09 (FR); LEMAITRE, Noëlla, 38054 Grenoble cedex 09 (FR); CROS, Stéphane, 38054 Grenoble cedex 09 (FR); FIEVEZ, Mathilde, 38054 Grenoble cedex 09 (FR)
(74) Mandataire: Germain Maureau

(57) **Abrégé**

Procédé de fabrication d'une couche de pérovskite (100) à multi-cations, comprenant :
- a) fourniture d'un substrat (1) présentant une face de dépôt (2),
- b) dépôt d'une solution précurseur comprenant des précurseurs comprenant du CsX, FAY, PbZ₂, avec X, Y et Z = I, Br, et un additif FACl, le rapport molaire du césium par rapport au plomb est compris entre environ 4% et 22 %, le rapport molaire du FACl par rapport au plomb étant compris entre 0.1% et 5%, et la couche de pérovskite (100) présente une formule brute du type CsₓFA_{(1-x+w)}Pb(I_{y}Br_{(1-y)})₃ avec x compris entre 0,04 et 0,22, y compris entre 0 et 1 et w compris entre 0,001 et 0,05,
- c) balayage du film humide (5) par un gaz inerte pour cristalliser la couche de pérovskite (100), et traitement thermique de sorte que la face de dépôt (2) présente une température allant d'environ 25°C à 80°C au moins pendant l'étape b).

## Description

La présente invention se rapporte au domaine des couches en matériau de type pérovskite pour des applications dans le domaine microélectronique et optoélectronique. Plus particulièrement, la présente invention concerne un procédé de fabrication d'une couche de pérovskite hybride halogénée photo-active, et notamment une couche de pérovskite à multi-cations, pour une utilisation dans les dispositifs photovoltaïques, les LED's, les photo-détecteurs, les micro-batteries, ou autres dispositifs utilisant leurs propriétés semi-conductrices.

Les pérovskites hybrides halogénées sont des matériaux prometteurs et beaucoup de développements sont mis en oeuvre afin d'améliorer leur qualité et leur stabilité, notamment pour la fabrication de cellules solaires. En effet, les cellules solaires hybrides organiques-inorganiques de pérovskite aux halogénures de plomb ont montré une augmentation remarquable de l'efficacité de conversion d'énergie sur une période de temps relativement courte (10 ans). Toutefois, les défis de cette technologie sont 1) la mise à l'échelle des procédés de dépôt des différentes couches, tout particulièrement de la couche pérovskite, 2) la stabilité des dispositifs photovoltaïques sous conditions réelles et 3) la présence de Pb dans la couche absorbante de ces dispositifs. Cette invention s'intéresse au premier point. En effet, la majeure partie des procédés de fabrication qui ont été développés à ce jour pour déposer un matériau pérovskite ayant des propriétés physiques et optoélectroniques menant à des performances photovoltaïques élevées (>20%) sont réalisés à l'échelle du laboratoire, sur des petites surfaces. Ainsi, il subsiste un besoin de design et d'optimisation de procédés permettant la fabrication de couches pérovskites de qualité, à l'échelle industrielle, un coût raisonnable et sans dégradation de leurs propriétés.

Lorsqu'une méthode de dépôt à la tournette communément dénommée 'spin coating' est utilisée, les précurseurs de la couche de pérovskite visée sont mis en solution pour être étalés sur un substrat entrainé en rotation. La projection d'un anti-solvant sur le substrat en rotation permet d'amorcer la nucléation de la pérovskite et ainsi d'obtenir des films couvrants de grande qualité optoélectronique. Toutefois, lorsque cette méthode de dépôt est utilisée sur une grande surface, un film humide non-homogène est produit, par inhomogénéité de l'effet centrifuge. D'autres méthodes de dépôt existent tel que le blade coating, le slot die coating, ou l'inkjet printing, etc... Bien que ces méthodes soient plus adaptées au dépôt d'une solution précurseur à l'échelle industrielle, un problème majeur réside dans la difficulté d'obtenir la cristallisation du film de pérovskite étalé sur le substrat, quelle que soit la méthode de formation du film. L'utilisation de la méthode de l'anti-solvant, reposant sur l'effet centrifuge est peu adaptée aux substrats de grande dimension. De plus, cette méthode utilise classiquement un solvant toxique ou dangereux (chlorobenzène ou toluène) avec des opérateurs travaillant en boîtes à gants, environnement non adapté pour une utilisation à l'échelle industrielle.

Enfin, lors de la mise en oeuvre sous air, souhaitable pour une application à l'échelle industrielle, les dispositifs obtenus peuvent présenter des performances limitées, notamment en terme de Voc.

Un des buts de la présente invention vise à pallier au moins l'un de ces inconvénients. A cet effet, l'invention propose un procédé de fabrication d'une couche de pérovskite à multi-cations, en vue de former une couche photo-active, le procédé comprenant les étapes de :
- a) fourniture d'un substrat présentant une face de dépôt,
- b) dépôt d'une solution précurseur comprenant au moins un solvant et des précurseurs de la pérovskite de sorte à former un film humide sur la face de dépôt, les précurseurs comprenant au moins du CsX, FAY, PbZ₂, avec X, Y et Z = I, Br, et un additif de FACI, les quantités étant déterminées de sorte que le rapport molaire du césium par rapport au plomb est compris entre environ 4% et 22 %, de préférence entre 13% et 20%, que le rapport molaire du FACI par rapport au plomb est compris entre 0,1% et 5%, en particulier entre 0,1% et 2%, et que la couche de pérovskite présente une formule brute du type CsₓFA_{(1-x+w)}Pb(I_{y}Br_{(1-y)})₃ avec x compris entre 0,04 et 0,22, y compris entre 0 et 1, et w compris entre 0.001 et 0.05, et
- c) balayage d'une surface exposée du film humide par un flux d'air sec ou de gaz inerte présentant une vitesse supérieure ou égale à 120 m/s de sorte à cristalliser la couche de pérovskite à multi-cations,
le procédé comprenant en outre l'application d'un traitement thermique sur le substrat de sorte que la face de dépôt présente une température allant d'environ 25°C à 80°C au moins pendant l'étape b).

Contre toute attente, cette combinaison de paramètres relatifs au traitement thermique appliqué au substrat, la composition de la solution précurseur utilisée, la présence d'un additif chloré, la méthode de dépôt et la méthode de cristallisation, notamment la vitesse du flux gazeux associée à la composition de la solution précurseur, permet d'obtenir une couche de pérovskite de très bonne qualité cristalline, sur l'ensemble de sa surface, comme on pourra le voir ci-après. De plus, la fabrication de cellules photovoltaïques utilisant la couche de pérovskite photo-active ainsi fabriquée donne des résultats d'efficacité similaires à ceux obtenu avec une couche déposée par 'spin coating'. Par ailleurs, la présence de l'additif FACI permet de limiter voire supprimer l'apparition du pic de Pbl₂ (analyses XRD) suite à un traitement thermique prolongé, telle que classiquement observée, comme on le verra en détail dans la suite de la description.

Dans le présent document, on entend par 'couche de pérovskite' une couche polycristalline de pérovskite (phase alpha), par opposition notamment à une couche amorphe ou une phase delta jaune et non absorbante dans la gamme souhaitée. Dans le présent document, le terme FA est bien connu par l'homme de l'art dans le domaine des pérovskites et désigne le Formamidinium HC(NH₂)₂⁺.

La couche de pérovskite obtenue à l'issue du procédé n'est pas parfaitement stœchiométrique. Il a déjà été relaté que la pérovskite existe sous forme « sous » ou « sur-stoechiométrique », selon le mode d'obtention, sans nécessairement affecter sa qualité cristalline ni ses propriétés d'absorption (se reporter à 'Critical Assessment of the Use of Excess Lead lodide in Lead Halide Perovskite Solar Cells' de Bart Roose et al. dans J. Phys. Chem. Lett. 2020, 11, 16, 6505-6512 ou à 'Fractional déviations in precursor stoichiometry dictate the properties, performance and stability of perovskite photovoltaic devices' de Paul Fassl et al. dans Energy Environ. Sci., 2018, 11, 3380-3391).

Toutefois, comme déjà rapporté à plusieurs reprises et notamment par Qi Jiang et al. 'Surface passivation of perovskite film for efficient solar cells' dans Nature Photonics Volume 13, pages 460-466 (2019), et par Jason J. Yoo et al. 'An interface stabilized pérovskite solar cell with high stabilized efficiency and low voltage loss' dans Energy & Environmental Science Issue 7, 2019', lors de l'utilisation de PbCl₂ pour former des pérovskites à base de MA (et initialement de la MAPbl₃), il a été observé dans le cadre de l'invention que le chlore de l'additif FACl n'était pas ou très peu intégré dans la maille cristalline de la couche de pérovskite formée à l'issue du procédé. Certaines hypothèses émises font part d'une éventuelle évaporation lors de traitement thermique de cristallisation pour expliquer son absence dans la pérovskite obtenue.

Par ailleurs, la technique de dépôt utilisée dans le procédé de l'invention peut être avantageusement utilisée à échelle industrielle, le dépôt sur une surface de 5 × 5 cm² a d'ailleurs donné de bons résultats. Les poudres des matériaux précurseurs utilisés ne sont pas instables et sont donc compatibles avec une solution industrielle. La cristallisation selon l'invention ne nécessite pas l'application de recuit thermique important postérieur à l'étape c) d'application de flux gazeux, ce qui réduit les coûts de fabrication et d'éventuels endommagements dans la structure cristalline. Néanmoins, si un tel recuit thermique devait être appliqué, la présence de l'additif FACl permet de limiter l'apparition de domaines de Pbl₂ cristallisé, potentiellement dommageables pour les rendements de la couche de pérovskite obtenue, comme on le verra en détail dans la suite de la description.

En outre, le spectre d'absorption des pérovskites hybrides formées par le procédé de la présente invention, présentant une formule brute du type CsₓFA_{(1-x+w)}Pb(I_{y}Br_{(1-y)})₃ comprenant du plomb, des halogénures et deux cations est très intéressant et peut être modifié notamment en ajustant le taux des halogénures dans la composition.

Il est également entendu par l'expression 'air sec', un air comprimé (8 bar) dont le point de rosée est inférieur à -20°C, et de préférence le point de rosée est inférieur à -40°C.

Selon une disposition, la surface exposée du film humide correspond à la totalité de la face exposée du film humide de sorte que la totalité du film humide est balayée par le flux d'air sec ou de gaz inerte.

Selon une possibilité, l'application d'un traitement thermique sur le substrat est réalisée de sorte que la face de dépôt présente une température allant entre 30°C et 70°C, et de préférence entre environ 40°C et 60°C. Il est en effet intéressant de limiter le traitement thermique appliqué au substrat pour des raisons économiques. Si le solvant du film humide s'évapore moins facilement à 40°C qu'à 80°C, il est possible de compenser en augmentant la vitesse du flux gazeux.

Selon une disposition, ledit traitement thermique est apliqué sur le substrat de sorte que la face de dépôt présente une température allant d'environ 25°C à 80°C pendant l'étape b) et l'étape c).

Selon une variante de réalisation, les précurseurs de la couche de pérovskite sont choisis parmi une combinaison de CsX, FAY et PbZ₂, avec X, Y et Z = I , Br, et d'additif FACI. Autrement dit, dans cette variante la solution de précurseurs est dépourvue d'autres précurseurs ou additif que ceux mentionnés dans la liste ci dessus.

Selon une autre possibilité, la solution précurseur consiste en les précurseurs choisis parmi du CsX, FAY, PbZ₂, et toute leur combinaison, avec X, Y et Z choisi parmi I et Br, l'additif FACI et au moins un solvant. Autrement dit, la solution précurseur est dépourvue de tout élément autre qu'au moins un solvant, les précurseur CsX, FAX, PbX₂, et toute leur combinaison, avec X choisi parmi I et Br et l'additif FACI. La composition de la solution précurseur est ainsi dépourvue de tout autre additif, ou de cation MA⁺ (méthylammonium) dont la présence peut altérer la stabilité de la couche obtenue.

Selon une possibilité, l'au moins un solvant est choisi parmi le DMF et/ou le DMSO. Le choix de la composition de l'au moins un solvant est un élément important pour faciliter la préparation de la solution précurseur par dissolution des éléments précurseurs du matériau pérovskite et de l'additif FACI, et la cristallisation qui implique l'évaporation dudit au moins un solvant.

Selon une disposition, la solution précurseur comprend une concentration molaire de plomb comprise entre 0,5 M et 1,7 M, en particulier entre 0,6 et 1.5 M et par exemple entre 1 M et 1,3 M.

De préférence, le seul budget thermique appliqué pendant le procédé de fabrication est fourni par le traitement thermique appliqué au substrat de sorte que la face de dépôt présente une température allant d'environ 25°C à 80°C pendant les étapes b) et c). En pratique, ledit traitement thermique est appliqué avant l'étape b) de dépôt de sorte que la face de dépôt présente la température souhaitée au moment de démarrer le dépôt et il est stoppé à la fin de l'étape c).

Selon une autre possibilité, l'étape c) d'application du flux de gaz inerte ou d'air sec est suivie, après obtention de la couche de pérovskite cristalline, d'une étape d) d'application d'un recuit thermique réalisé à une température comprise entre 70°C et 100°C. La durée de ce recuit thermique est comprise entre environ 5 minutes et 60 minutes et selon une disposition entre 5 et 30 minutes. Cette option peut être utile pour certaines formules brutes de pérovskite visées, selon les valeurs de x , y et w de la formule brute CsₓFA_{(1-x+w)}Pb(I_{y}Br_{(1-y)})₃, on peut souhaiter faire disparaitre toute trace infime de matériaux précurseurs ou de solvant résiduel qui ne serait pas éliminée à l'étape c). Cette éventuelle étape d) diffère du recuit thermique connu dans l'art antérieur notamment par sa durée.

Toutefois, des recuits prolongés peuvent être appliqués après l'étape c) sans pour autant voir apparaitre du Pbl₂ (signal visible par DRX), comme généralement observé en absence de FACI. Des recuits à 100°C pendant une durée de 60 min sont notamment réalisables sous atmosphère inerte. L'ajout de l'additif FACI peut permettre d'augmenter la plage de temps de recuit sans voir se dégrader la couche de pérovskite.

De préférence, l'étape c) de balayage par un flux de gaz inerte ou d'air sec est réalisée par un déplacement relatif du substrat comprenant le film humide et d'une buse de projection, telle qu'une buse de projection d'un couteau à gaz, la buse de projection étant disposée de sorte que la longueur L de la trajectoire du flux du gaz inerte ou d'air sec entre la sortie de la buse de projection et la surface exposée du film humide est comprise entre environ 3,1 millimètres et 6 millimètres, et de préférence entre environ 3,1 millimètres et 4 millimètres.

Plus précisément, la sortie de la buse de projection est délimitée par une lèvre basse et une lèvre haute espacées l'une de l'autre de sorte à former un espace de projection du flux de gaz inerte ou d'air sec sous une forme globale de lame, la lèvre basse définissant un point bas B et la lèvre haute définissant un point haut H. Il est entendu dans le présent document que la longueur L de la trajectoire du flux du gaz inerte ou d'air sec entre la sortie de la buse de projection et la surface exposée du film humide est mesurée entre le point haut H et la surface exposée du film humide. Comme on le verra ci-après et en référence aux figures annexées 4 et 5, ladite longueur L dépend de l'angle α formé entre le film humide et la direction du flux de gaz inerte ou d'air sec.

Il est entendu que la vitesse du flux du gaz inerte ou de l'air sec indiquée dans le présent document est mesurée et/ ou calculée à la sortie d'une buse de projection d'un dispositif de projection dudit flux. La vitesse du flux est fonction du débit de gaz et de la surface de l'ouverture à la sortie de la buse de projection.

Dans le présent document, l'expression 'couteau à gaz' ou 'couteau d'air' correspond à l'expression bien connue de l'homme du métier sous l'appelation anglosaxonne respectivement « gas knife » et « air knife ».

De préférence, la vitesse de déplacement relatif entre le film humide et la buse de projection lors de l'étape c) est comprise entre 1 et 50 mm/s et de préférence entre 5 et 30 mm/s.

Selon une disposition, l'angle α formé entre le flux de gaz inerte ou d'air sec et le film humide est compris entre 90° et 45°.

Avantageusement, l'étape b) de dépôt de la solution précurseur est effectuée par enduction via une filière plate ou via un couchage à lame, de sorte à obtenir un film humide d'une épaisseur constante et d'une concentration homogène. Ces techniques de dépôt sont en effet utilisées sur de grandes surfaces de dépôt nécessaires dans une solution industrielle.

Dans le présent document, l'expression 'enduction via une filière plate' correspond à la technique bien connue de l'homme du métier sous la dénomniation anglosaxone `slot die coating'. De la même façon, l'enduction par couchage à lame correspond à la technique bien connue de l'homme du métier sous la dénomniation anglosaxone `blade coating' parfois également nommée enduction par `lame à enduction'.

Selon une disposition, l'étape b) de dépôt consiste à déposer la solution précurseur par une tête de dépôt du dispositif de slot die coating sur la face de dépôt, avec un débit compris entre 80 et 125 microlitre/min pour une concentration molaire du plomb dans la solution précurseur comprise entre 1 M et 1,3 M.

Selon une possibilité, l'étape b) de dépôt de la solution précurseur est réalisée de sorte à obtenir une épaisseur de film humide constante, comprise entre 2 et 16 micromètres préférentiellement entre 2,5 et 8 micromètres et de préférence encore entre 3 et 5 micromètres.

Ces plages d'épaisseurs du film humide garantissent qu'il est possible à l'étape c) d'obtenir la cristallisation de la couche de pérovskite avec une bonne qualité et un bon rendement. Ces épaisseurs dépendent bien entendu de la concentration de la solution précurseur pour obtenir une couche de pérovskite cristalline d'une épaisseur comprise dans une plage d'environ 350- 600 nm.

Afin de diminuer le budget thermique appliqué aux étapes b) et c) tout en maitenant une bonne cristallisaiton de la couche de pérovksite, il est possible de limiter la vitesse de balayage du film par la buse de projection.

Un autre levier consiste à modifier la concentration dans la solution précurseur, au sein des plages ci-dessus indiquées.

Il est également possible de se placer dans une partie basse de la plage de la longueur L de la trajectoire du flux gazeux . En pratique, la buse de projection est rapprochée de la surface exposée du film humide, avec une distance verticale D entre 100 à 400 micromètres par exemple.

Une autre option consiste à choisir une vitesse du flux de gaz inerte ou d'air sec pamir les plus rapides des possibilités offertes par la buse de projection, par exemple de 135 m/s à 250 m/s.

Selon d'autres caractéristiques, le procédé de fabrication de l'invention comporte une ou plusieurs des caractéristiques optionnelles suivantes considérées seules ou en combinaison :
- La vitesse relative entre la face de dépôt et la tête de dépôt (cas du slot die coating) de la solution précurseur ou de la lame d'étalement (cas du blade coating) est comprise entre environ 1 et 100 mm/s et de préférence entre 15 et 45 mm/s et encore de préférence entre environ 20 et 30 mm/s.
- L'application du flux de gaz inerte ou d'air sec selon l'étape c) est réalisé sur la surface exposée du film humide avant la fin du dépôt de la solution précurseur selon l'étape b).
- L'application du flux de gaz inerte ou d'air sec selon l'étape c) est réalisé sur la surface exposée du film humide après la fin du dépôt de la solution précurseur selon l'étape b).
- La vitesse relative entre la tête de dépôt ou la lame d'étalement de la solution précurseur et la face de dépôt est similaire à la vitesse relative entre le film humide et la buse de projection du flux de gaz inerte ou d'air sec.
- La vitesse relative entre la tête de dépôt ou la lame d'étalement et la face de dépôt est supérieure à la vitesse relative entre le film humide et la buse de projection du flux de gaz inerte ou d'air sec.
- La vitesse relative entre la tête de dépôt ou la lame d'étalement et la face de dépôt est inférieure à la vitesse relative entre le film humide et la buse de projection du flux de gaz inerte ou d'air sec.
- Le déplacement entre la face de dépôt et la tête de dépôt (ou la lame d'étalement) et le déplacement entre la surface exposée du film humide et la buse de projection consiste en mouvement de translation, dans la direction d'extension longitudinale de la face de dépôt.
- Le flux d'air sec ou de gaz inerte est distribué à partir d'une source de gaz comprimé. Il est projeté sur la surface exposée du film humide à une température d'environ 15°C à 25°C sans étape de réchauffage intermédiaire.
- Le flux d'air sec ou de gaz inerte présente une vitesse comprise entre 120 m/s et 250 m/s. lors de l'étape c).
- La distance verticale D entre la surface exposée du film humide et le point B de la sortie de la buse de projection est comprise entre 100 micromètres et 1 mm et de préférence entre 200 et 400 micromètres.
- La buse de projection est dépourvue de méplat de sorte que M = 0 et le point bas B et le point haut H sont à la même distance verticale D de la surface exposée du film humide.
- Le traitement thermique du substrat est réalisé en plaçant le substrat sur une plateforme chauffante dédiée, de sorte que le support est chauffé au travers une face opposée à la face de dépôt du film humide.
- Le traitement thermique est stoppé à la fin de l'étape b).
- La tête de dépôt de la solution précurseur est disposée à une distance, mesurée à l'aplomb de la face de dépôt, comprise entre 25 et 500 micromètres et de préférence entre environ 80 et 125 micromètres, et encore de préférence environ 100 micromètres.
- La distance entre la lame d'étalement lors du blade coating et la face de dépôt est comprise entre 25 et 200 micromètres et en particulier entre 50 et 100 micromètres.
- Les étapes a) à c) et le traitement thermique sont réalisées dans une enceinte de salle blanche présentant une température comprise entre 20 et 35°C.
- Les étapes a) à c) et le traitement thermique sont réalisées dans une enceinte de salle blanche présentant un taux d'humidité relative compris entre 8 et 38%.
- La salle blanche présente une température d'environ 21°C et un taux d'humidité relative d'environ 35%.
- La couche de pérovskite obtenue à l'étape c) présente une épaisseur d'environ 500 nanomètres.
- Le procédé de fabrication est dépourvu d'un traitement anti-solvant de conversion du film humide en film cristallin.
- Le substrat utilisé pour le dépôt est un substrat de type wafer de quelques centaines de micromètres, par exemple en silicium ou en verre, ou bien un substrat mince et souple se présentant sous une forme enroulée. Dans ce dernier cas, le substrat est entrainé par un mouvement de translation conduisant à son déroulement et son déplacement sous le dispositif de slot die coating ou de blade coating immobiles, et sous la buse de projection de flux de gaz inerte ou d'air sec également immobile.

L'invention sera davantage comprise à la lecture de la description non limitative qui va suivre, faite en référence aux figures ci-annexées.
La Figure 1 est une vue schématique illustrant les étape a) à b) d'un mode de réalisation du procédé de l'invention.
La Figure 2 est une vue schématique illustrant les étape b) et c) du procédé de l'invention.
La Figure 3 est une vue schématique illustrant l'étape c) du procédé de l'invention.
La Figure 4 est une vue schématique de la sortie d'une buse de projection du flux de gaz selon l'étape c) du procédé de l'invention.
La Figure 5 est une vue schématique d'une buse de projection inclinée selon l'étape c) du procédé de l'invention.
La Figure 6 est une vue schématique d'une architecture de la structure pour cellule solaire de type NIP formée à partir d'une couche de pérovskite 100 fabriquée selon un mode de réalisation du procédé de l'invention.
La Figure 7 est une vue d'une analyse par diffraction aux rayons X (DRX) de la structure pour cellule solaire de type NIP sans additif FACI.
La Figure 8 est une vue de DRX de la structure pour cellule solaire de type NIP comprenant un rapport molaire 0,1% de FACI par rapport au plomb selon un mode de réalisation du procédé de l'invention.
La Figure 9 est une vue d'une analyse DRX de la structure pour cellule solaire de type NIP comprenant un rapport molaire 0,5% de FACI par rapport au plomb selon un mode de réalisation du procédé de l'invention.
La Figure 10 est une vue d'une analyse DRX de la structure pour cellule solaire de type PIN sans additif FACI.
La Figure 11 est une vue d'une analyse DRX de la structure pour cellule solaire de type PIN comprenant un rapport molaire 0,1% de FACI par rapport au plomb selon un mode de réalisation du procédé de l'invention.
La Figure 12 est une vue d'une analyse DRX de la structure pour cellule solaire de type PIN comprenant un rapport molaire 0,5% de FACI par rapport au plomb selon un mode de réalisation du procédé de l'invention.

Dans les exemples suivants, le Pbl₂ utilisé est pur à 99,99% et provient de chez TCI Chemicals (Japon), le PbBr₂, FAI, Csl, FACI, DMF et DMSO proviennent de chez Sigma Aldrich.

Le couteau à gaz utilisé est l'équipement Silent X-Stream Air Blade, disponible chez fournisseur AirFlow.

Le slot die coating est réalisé à l'aide de l'équipement Automatic-Research TFC 300.

Le blade coating est réalisé à l'aide d'une lame de dépôt Zehntner ZUA 2000.

Dans ces exemples décrits ci-dessous, le substrat 1 et la face de dépôt 2 sont immobiles mais selon une disposition particulière, le substrat 1 et donc la face de dépôt 2 se déplace tandis que le dispositif de dépôt du film humide (blade coating) et le dispositif de projection du flux gazeux (couteau à gaz) sont immobiles (cas du substrat souple se présentant sous forme enroulée).

### Premier exemple de réalisation du procédé de fabrication d'une couche de pérovskite 100 cristalline selon l'invention par blade coating :

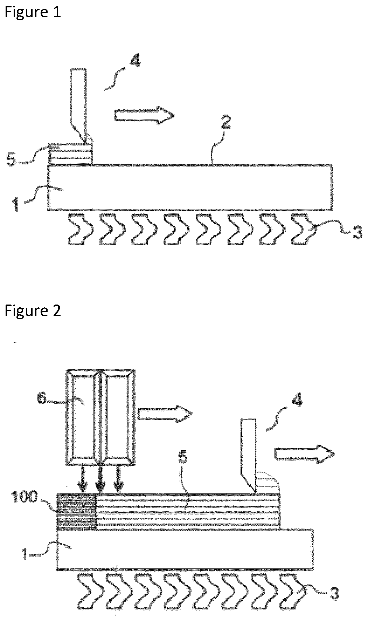

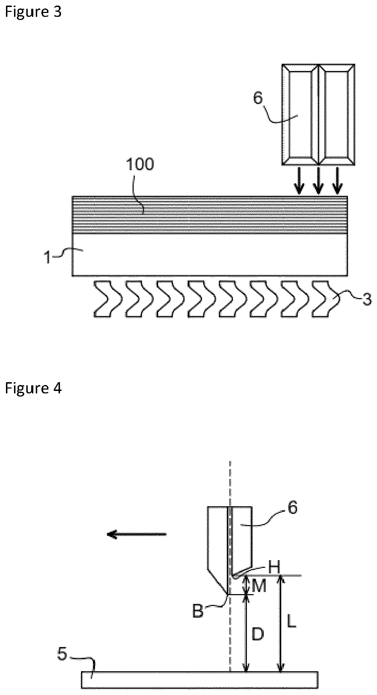

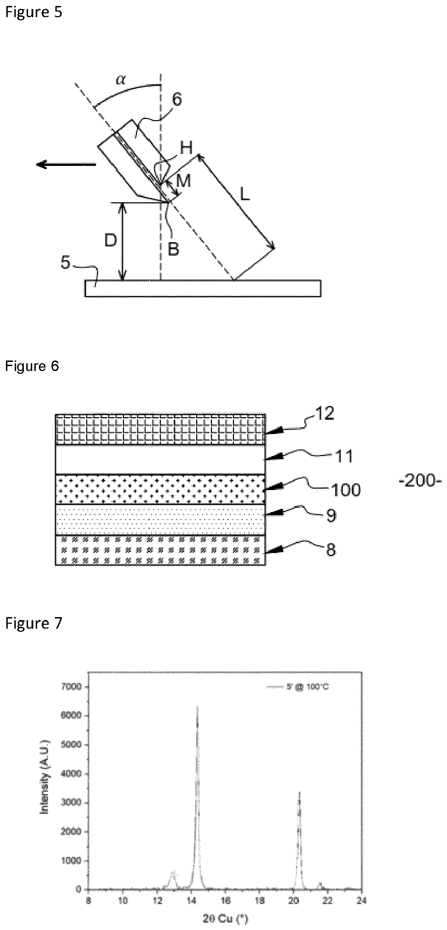

Les étapes du procédé sont illustrées sur les figures 1 à 3. La figure 1 illustre l'étape a) du procédé consistant à fournir un substrat 1 comportant une face de dépôt 2 sur une plateforme chauffante 3 dans une enceinte à atmosphère contrôlée (température d'environ 21°C et un taux d'humidité relative d'environ 20%). Dans le cadre de la préparation de dispositifs photovoltaïques, le substrat 1 utilisé est une structure (5 cm × 5 cm) constituée d'un support en verre 7 (épaisseur 1.1 mm), recouvert d'une couche de ITO 8 (couche d'oxyde d'indium et d'étain d'épaisseur environ 220 nm) elle-même recouverte d'une couche de SnOz 9 (oxyde d'étain) préparée en vue de fabriquer une cellule solaire de type NIP (illustrée en figure 6). Typiquement, la couche de SnO₂ a été déposée au préalable par spin coating ou slot-die coating puis séchée à 80°C pendant une minute. Elle présente une épaisseur d'environ 50 nm et sa rugosité est d'environ 5 nm.

Un substrat 1 constitué d'une structure pour cellule solaire de type PIN peut également être utilisé, tout comme un substrat 1 permettant de fabriquer une structure de type tandem utilisant du silicium. Dans le cas d'une architecture de type PIN, une monocouche auto-assemblée de 2-Pacz (ou [2-(9H-Carbazol-9-yl)ethyl] phosphonic Acid fourni par la société TCI America - numéro CAS : 20999-38-6 ) forme la couche d'extraction de trous 11 ou `hole extracting layer'. Cette couche 11 est déposée par spin-coating sur le substrat Verre ITO préalablement traité à l'UV-ozone.

Un traitement thermique est appliqué via la plateforme chauffante 3 sur le substrat 1 au travers de la face opposée à la face de dépôt 2. Ce traitement thermique est contrôlé de sorte que la température de la face de dépôt 2 du substrat 1 soit maintenue à environ 40°C.

Une solution précurseur est préparée à partir des quantités de précurseurs suivants Pbl₂, (3,707g), PbBr₂ (1,453g), FAI (1,631g), Csl (0,468g) et l'additif FACI (9,7 mg), dissous dans 12 ml d'un mélange de solvant composé de 10,8 ml de DMF et un 1,2 ml de DMSO. La concentration du Pb dans la solution est d'environ 1 M, le rapport molaire de Cs sur le Pb est d'environ 15% et le rapport molaire de FACI sur le Pb est d'environ 0,1 %.

Après agitation de la solution précurseur à 40°C environ 12h, le dépôt est réalisé par un dispositif de 'blade coating' sur une face de dépôt 2 du substrat 1 présentant une température d'environ 40°C. La distance entre la lame d'étalement 4 du dispositif 'blade coating' et la face de dépôt 2 du substrat 1 est d'environ 70 micromètres. La vitesse relative entre la face de dépôt 2 et la lame d'étalement 4 est de 20 mm/s et le volume d'encre utilisé est de 20 microlitres. Le flux d'azote est appliqué sur la surface exposée du film humide 5 avec une vitesse d'environ 137 m/s. La buse de projection 6 du flux d'azote est disposée de sorte que la longueur L de la trajectoire du flux gazeux est d'environ 3,6 mm. La buse 6 se déplace à une vitesse de 5 mm/s.

La buse de projection 6 est orientée de sorte que le flux d'azote est projeté en formant un angle α de 50° avec la surface exposée du film humide 5. Selon une étape d) (non illustrée) du procédé, un traitement thermique d'une durée de 5 minutes à une température de 100°C sous atmosphère inerte est réalisée après le passage de la buse de projection. Une couche de pérovskite 100 cristalline de formule brute Cs_{0.15}FA_{0.79}Pb(I_{0.78}Br_{0.22})_{2.94} est obtenue avec une grande qualité (la précision concernant les valeurs de la formule brute est limitée à deux décimales).

Des essais de recuit prolongés ont également été réalisés, avec une durée de recuit totale de 60 minutes à 100°C, toujours sous atmosphère inerte.

### Deuxième exemple de réalisation du procédé de fabrication d'une couche de pérovskite 100 cristalline selon l'invention par blade coating :

Dans ce second exemple, la solution précurseur présente les quantités de précurseurs suivants Pbl₂, (3,707g), PbBr₂ (1,453g), FAI (1,631g), Csl (0,468g) et FACI (48,3 mg) dissous dans 12 ml d'un mélange composé de 10,8 ml de DMF et un 1,2 ml de DMSO. La concentration du Pb dans la solution est d'environ 1 M, le rapport molaire de Cs sur le Pb est d'environ 15% et le rapport molaire de FACI sur le Pb est d'environ 0,5%.
Les autres paramètres décrits pour le premier exemple de réalisation sont identiques pour ce deuxième exemple de réalisation.
Bien que cela ne soit pas décrit dans les exemples, le dépôt de la solution précurseur par slot die coating est une voie de dépôt possible.

### Analyses et mesures réalisées à partir des couches de pérovskites formées selon le procédé de fabrication de l'invention :

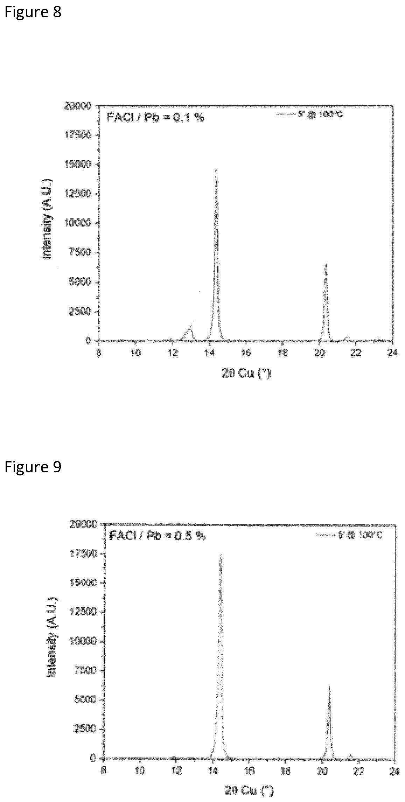

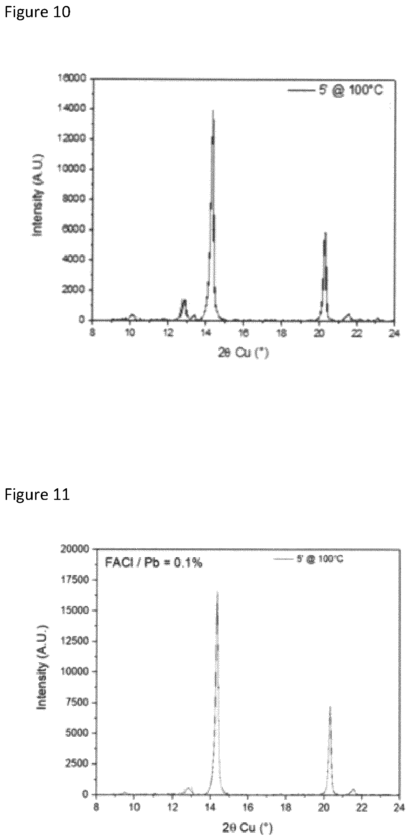

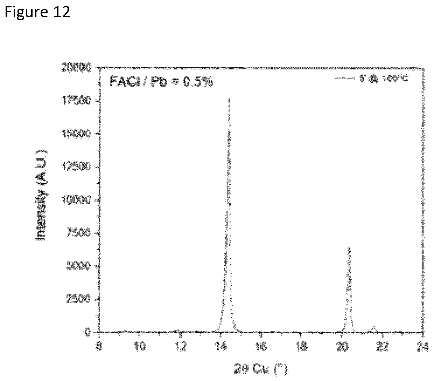

Différentes couches de pérovskite 100 ont été fabriquées par un dispositif de blade coating pour des rapports molaires FACI/Pb de 0,1 et 0,5% en architecture NIP (figures 8 et 9) et PIN (figures 11 et 12) (les autres éléments restant inchangés). Les mêmes analyses ont également été réalisées sur des couches préparées à partir d'une solution précurseur ne contenant pas l'additif FACI, et servent donc de référence (figure 7 pour le NIP et figure 10 pour le PIN).

Les analyses DRX (acronyme de Diffraction aux Rayons X) des couches formées montrent qu'une couche de pérovskite 100 polycristalline (phase alpha, ou phase dite noire) est bien présente que ce soit à 0,1 ou 0,5% de rapport molaire de FACI avec une absence totale d'une phase delta (ou phase dite jaune, non souhaitée).

Par ailleurs, un taux de 0.5% de l'additif FACI permet de limiter, voire de supprimer l'apparition du signal relatif au Pbl₂ (entre 12,5° et 13°) que ce soit en architecture NIP ou PIN (se rapporter à la figure 9 ou 12) alors que ce signal est bien présent pour la solution de référence (figure 7 ou 10) et pour la solution comprenant un rapport molaire FACI/Pb de 0.1%, le pic de Pbl₂ est d'ailleurs augmenté avec une recuit prolongé à 60 minutes à 100°C (non illustré). De façon intéressante, pour ce taux en FACI de 0,5%, le pic relatif au Pbl₂ n'est pas non plus observé après un recuit prolongé (durée totale de 60 minutes- non illustré).

### Mise en oeuvre des couches de pérovskite préparées selon l'invention dans des cellules solaires :

### Configuration dite N-I-P :

Les couches de pérovskite 100 préparées telles que précédemment décrites sont déposées sur des substrats 1 comprenant un support 7 en verre, une couche d'ITO 8 (électrode transparente) / une couche de SnO₂ 9 (couche d'extraction d'électrons ou `electron extracting layer') de forme carrée de 5 cm × 5 cm. Afin de terminer la fabrication du dispositif, une couche d'extraction de trous 11 communément appelée `holes extracting layer' de PTAA dopé est déposée par dépôt à la tournette sur la couche de pérovskite 100, puis une électrode supérieure en or 12 est évaporée en surface (se référer à l'empilement de la figure 6).

### Configuration dite P-I-N :

Dans cette autre configuration, les couches de pérovskite préparées telles que précédemment décrites ci-dessus sont déposées sur des substrats comprenant un support en verre, une couche d'ITO (électrode transparente) / une monocouche auto-assemblée de 2-PACz (ou [2-(9H-Carbazol-9-yl) ethyl] phosphonic Acid fourni par la société TCI America - numéro CAS : 20999-38-6) formant la couche d'extraction de trous ou `hole extracting layer', de forme carrée de 5 cm × 5 cm. Afin de terminer la fabrication du dispositif, une couche d'extraction d'électrons communément appelée 'électrons extracting layer' de C₆₀ puis une couche de BCP (ou Bathocuproine, dérivé de la 1,10- phénantroline, fourni par Sigma Aldrich - numéro CAS 4733-39-5) et une électrode supérieure en argent sont évaporées en surface.

Les performances photovoltaïques des cellules solaires 200 ont été mesurées à 25 °C dans des conditions standards d'éclairement (1000 W.m⁻², AM 1,5 G) avec un simulateur solaire de la marque Newport. Les courbes courant-tension ont été enregistrées à l'aide d'un Keithley. Les résultats sont consignés dans le tableau 1 ci-dessous.

La première ligne du tableau 1 rapporte les résultats obtenus pour une couche de pérovskite déposée par le procédé de Dr Blade en architecture NIP sans l'additif FACI et sert de référence. Les résultats du premier exemple de réalisation de couche de pérovskite 100 avec additif (Dr Blade coating tel que précédemment décrit) en architecture NIP sont consignés à la deuxième ligne du tableau 1. Ces dispositifs ont été préparées sous forme de modules comprenant 8 bandes reliées en série avec une surface active totale de 10 cm².

Sur la troisième ligne du tableau 1 sont indiqués les résultats obtenus à partir de cellules 200 préparées en architecture PIN sans l'additif FACI et sert de référence. Les résultats de la réalisation de couche de pérovskite 100 avec additif (Dr Blade coating tel que précédemment décrit) en architecture PIN sont consignés à la quatrième ligne du tableau 1. Ces dispositifs ont été préparées sous forme de cellules unitaires de surface 33 mm².

**Tableau 1**

| **Conditions du dépôt** | **V_{OC} (mV)** | **J_{sc} (mA.cm⁻²)** | **FF (%)** | **PCE (%)** |
|---|---|---|---|---|
| Dépôt par blade coating⁽²⁾ (1M en Pb - Cs/Pb 15%) Architecture NIP **Référence Sans Additif** | 9280 | 2,54 | 69,4 | 16,4 |
| Dépôt par blade coating⁽²⁾ (1M en Pb - Cs/Pb 15%) Architecture NIP **Avec Additif FACI 0.5%** | 9635 | 2,44 | 77,5 | 18,2 |
| Dépôt par blade coating⁽¹⁾ (1M en Pb - Cs/Pb 15%) Architecture PIN **Référence Sans Additif** | 1028 | 19,5 | 67,4 | 13,5 |
| Dépôt par blade coating⁽¹⁾ (1M en Pb - Cs/Pb 15%) Architecture PIN **Avec Additif FACI 0.5%** | 1073 | 20,8 | 66,2 | 14,8 |

| | | | | |
|---|---|---|---|---|
| ⁽¹⁾ Meilleur résultat obtenu pour des cellules préparées sous forme de cellules unitaires de surface 33 mm² ⁽²⁾ Meilleur résultat obtenu pour des cellules préparées sous forme de modules comprenant 8 bandes de reliées en série. | | | | |

A la lecture du tableau, on peut constater que les performances des cellules solaires 200 sont augmentées pour la couche de pérovskite obtenue avec l'additif FACI. La présence de l'additif permet notamment d'améliorer significativement la Voc que ce soit en configuration NIP ou PIN. Ainsi, les couches de pérovskite 100 obtenues selon le procédé de la présente invention sont d'une grande qualité et peuvent être mise en oeuvre dans des cellules solaires de pérovskite très efficaces.

En conclusion, l'invention permet d'optimiser le procédé de fabrication d'une couche de pérovksite 100 à multi-cations. Elle permet de former une couche cristalline 100 de qualité, dans des conditions adaptées à une solution industrielle. L'intégration de ces couches dans des dispositifs de type cellule solaire 200 est possible et conduit à de très bons résultats.

## Revendications

1. Procédé de fabrication d'une couche de pérovskite (100) à multi-cations, en vue de former une couche photo-active, le procédé comprenant les étapes de :
- a) fourniture d'un substrat (1) présentant une face de dépôt (2),
- b) dépôt d'une solution précurseur comprenant au moins un solvant et des précurseurs de la pérovskite de sorte à former un film humide (5) sur la face de dépôt (2), le dépôt étant effectué par enduction via une filière plate ou via un couchage à lame, les précurseurs comprenant au moins du CsX, FAY, PbZ₂, avec X, Y et Z = I, Br, et un additif FACI, les quantités étant déterminées de sorte que le rapport molaire du césium par rapport au plomb est compris entre environ 4% et 22 %, de préférence entre 13% et 20%, que le rapport molaire du FACI par rapport au plomb est compris entre 0,1% et 5%, en particulier entre 0,1% et 2%, et que la couche de pérovskite (100) présente une formule brute du type CsₓFA_{(1-x+w)}Pb(I_{y}Br_{(1-y)})₃ avec x compris entre 0,04 et 0,22, y compris entre 0 et 1 et w compris entre 0,001 et 0,05, et
- c) balayage d'une surface exposée du film humide (5) par un flux d'air sec ou de gaz inerte présentant une vitesse supérieure ou égale à 120 m/s de sorte à cristalliser la couche de pérovskite (100) à multi-cations, le procédé comprenant en outre l'application d'un traitement thermique sur le substrat (1) de sorte que la face de dépôt (2) présente une température allant d'environ 25°C à 80°C au moins pendant l'étape b).

2. Procédé de fabrication selon la revendication précédente dans lequel l'application d'un traitement thermique sur le substrat (1) est réalisée de sorte que la face de dépôt (2) présente une température allant entre environ 30°C et 70°C, et de préférence entre environ 40°C et 60°C.

3. Procédé de fabrication selon l'une des revendications 1 à 2, dans lequel les précurseurs de la couche de pérovskite (100) sont choisis parmi une combinaison de CsX, FAY et PbZ₂, avec X, Y et Z = I , Br et l'additif FACI.

4. Procédé de fabrication selon l'une des revendications précédentes, dans lequel l'au moins un solvant est choisi parmi le DMF et /ou le DMSO.

5. Procédé de fabrication selon l'une des revendications précédentes, dans lequel la concentration molaire du plomb dans la solution précurseur est comprise entre 0.5 M et 1.7 M.

6. Procédé de fabrication selon l'une des revendications précédentes, dans lequel le seul budget thermique appliqué pendant le procédé de fabrication est fourni par le traitement thermique appliqué au substrat (1) de sorte que la face de dépôt (2) présente une température allant d'environ 25°C à 80°C pendant les étapes b) et c).

7. Procédé de fabrication selon l'une des revendications 1 à 5, dans lequel l'étape c) d'application du flux de gaz inerte ou d'air sec est suivie d'une étape d) d'application d'un recuit thermique réalisé à une température comprise entre 70°C et 100°C.

8. Procédé de fabrication selon l'une des revendications 1 à 7, dans lequel, l'étape c) de balayage par un flux de gaz inerte ou d'air sec est réalisée par un déplacement relatif du substrat (1) comprenant le film humide (5) et d'une buse de projection (6), telle qu'une buse de projection d'un couteau à gaz, la buse de projection étant disposée de sorte que la longueur (L) de la trajectoire du flux du gaz inerte ou de l'air sec entre la sortie de la buse de projection (6) et la surface exposée du film humide (5) est comprise entre environ 3,1 millimètres et 6 millimètres, et de préférence entre environ 3.1 millimètres et 4 millimètres.

9. Procédé de fabrication selon la revendication précédente dans lequel la vitesse de déplacement relatif entre le film humide (5) et la buse de projection (6) lors de l'étape c) est comprise entre 1 et 50 mm/s et de préférence entre 5 et 30 mm/s.

10. Procédé de fabrication selon la revendication 8 ou 9, dans lequel l'angle α formé entre le flux de gaz inerte ou d'air sec et le film humide est compris entre 90° et 45°.

11. Procédé de fabrication selon l'une des revendications précédentes dans lequel l'étape b) de dépôt de la solution précurseur est réalisée de sorte à obtenir une épaisseur de film humide (5) constante, comprise entre 2 et 16 micromètres préférentiellement entre 2,5 et 8 micromètres et de préférence encore entre 3 et 5 micromètres.
